# EUROPEAN PATENT APPLICATION

(11) **EP 4 270 511 A1**
(43) Date of publication of application: **01.11.2023**
(21) Application number: 21911409.7
(22) Date of filing: 17.12.2021
(51) Int. Cl.: H01L 51/42, H01L 31/0725, H01L 51/44, H01L 51/00, C07F 7/24

(54) **METHOD FOR MANUFACTURING SOLAR CELL, AND SOLAR CELL MANUFACTURED THEREBY**

(30) Priority: 24.12.2020 KR 20200183635
(71) Applicant: Hanwha Solutions Corporation, Jung-gu Seoul 04541 (KR)
(72) Inventor: JUNG, Kwang Ho, Uiwang-si Gyeonggi-do 16021 (KR)
(74) Representative: Mooser, Sebastian Thomas
(86) International application number: PCT/KR2021/019262
(87) International publication number: WO 2022/139342

(57) **Abstract**

The present invention relates to a method for manufacturing a solar cell, and the solar cell manufactured thereby, the method comprising a step for manufacturing a laminate in which a first electrode layer, a hole transport layer (HTL), a photoactive layer, an electron transport layer, and a second electrode layer are laminated in order, wherein the hole transport layer or the electron transport layer is formed by applying and drying a dispersion including a dispersion solvent, a hydroxide, and a metal oxide surface-modified with a carboxylic acid (R-COOH).

## Description

### [Technical Field]

The present invention relates to a method for manufacturing solar cells and a solar cell manufactured thereby and, more particularly, to a method for manufacturing perovskite solar cells, which enables formation of a uniform thin layer of a metal oxide, and a perovskite solar cell manufactured thereby.

### [Background Art]

Solar cells are the core device of a photovoltaic system that directly converts sunlight into electricity, and have been widely used as a power source in various places from home to space. Nowadays, solar cells are also used in aviation, meteorology, and telecommunications, and solar cars and solar air conditioners also attract attention.

Solar cells mainly use silicon semiconductors. However, power generation using such silicon solar cells has a problem of high power generation cost due to high prices of raw materials for high-purity silicon semiconductors and complexity of a solar cell manufacturing process. In other words, sine the power generation cost of a silicon solar cell-based power generation system is 3 to 10 times higher than that of a typical fossil fuel-based power generation system, there is a problem in that growth of the solar cell market depends on government intervention. For this reason, research efforts have been actively conducted to develop silicon-free solar cells and, since the 1990s, dye-sensitized solar cells (DSSCs) using organic semiconductor dyes and polymer solar cells using conductive polymers have been studied in earnest. Although organic semiconductor-based solar cells, such as DSSCs and polymer solar cells, have not yet reached the commercialization stage despite many efforts by academia and industry, the emergence of perovskite solar cells (PSCs), which combine advantages of DSSCs and polymer solar cells, has raised expectations for next-generation solar cells.

A perovskite solar cell is a hybrid of a DSSC and a polymer solar cell, has improved reliability by omitting a liquid electrolyte, like a DSSC, and is highly efficient due to good optical properties of perovskite. Recent improvements in related processes, materials, and structures have led to continuous improvement in efficiency of the perovskite solar cell.

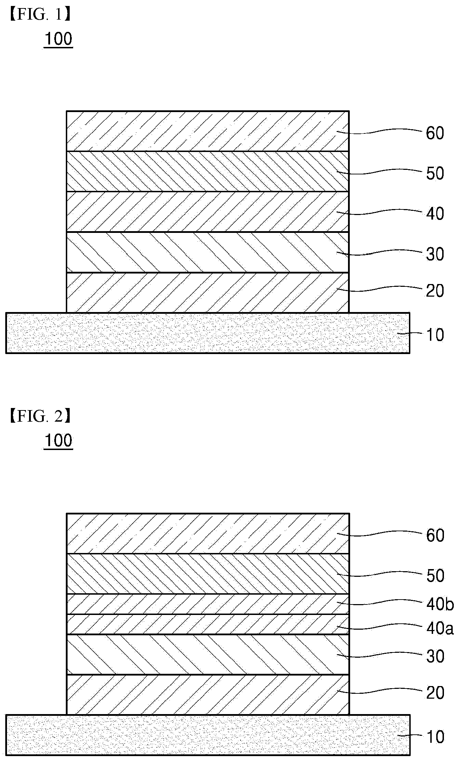

FIG. 1 is a side view of a solar cell. Referring to FIG. 1, a solar cell 100 includes a substrate layer 10, a first electrode layer 20, a hole transport layer 30, a photoactive layer 40, an electron transport layer 50, and a second electrode layer 60.

The hole transport layer 30 or the electron transport layer 50 of the solar cell 100 may include a thin metal oxide film. Use of the thin metal oxide film as the hole transport layer 30 is advantageous in that a metal oxide is highly stable and generally has high hole conductivity.

In order to form a uniform thin film of a metal oxide, the metal oxide may be subjected to surface modification with an acidic functional group, such as acetic acid (AA) or trifluoroacetic acid (TFA), to facilitate dispersion of the metal oxide in a dispersion solvent.

However, surface modification of the metal oxide cannot ensure sufficient dispersion of the metal oxide in a polar solvent, such as deionized water (DI water) or ethanol, despite efficiency in improvement in dispersion of the metal oxide in a non-polar solvent, such as isopropyl alcohol (IPA), which eventually leads to difficulty in formation of a thin metal oxide film using a dispersion including a metal oxide dispersed in a polar solvent.

### [Disclosure]

### [Technical Problem]

It is one object of the present invention to provide a method for manufacturing solar cells, which enables formation of a uniform thin film of a metal oxide by ensuring good dispersion of a surface-modified metal oxide not only in a non-polar solvent but also in a polar solvent.

It is another object of the present invention to provide a solar cell manufactured by the method for manufacturing solar cells.

It will be understood that objects of the present invention are not limited to the above. The above and other objects of the present invention will become apparent to those skilled in the art from the detailed description of the following embodiments in conjunction with the accompanying drawings.

### [Technical Solution]

In accordance with one aspect of the present invention, a method for manufacturing solar cells includes manufacturing a stack including a first electrode layer, a hole transport layer (HTL), a photoactive layer, an electron transport layer, and a second electrode layer stacked in sequence, wherein the hole transport layer or the electron transport layer is formed by applying and drying a dispersion including a metal oxide subjected to surface modification with a carboxylic acid (R-COOH), a dispersion solvent, and a hydroxide.

The dispersion may have a pH of 8 to 13.

The hydroxide may be one selected from the group consisting of NH₄OH, LiOH, NaOH, KOH, RbOH, CsOH, tetramethylammonium hydroxide (TMAH), and tetrabutylammonium hydroxide (TBMH), or a mixture thereof.

The metal oxide may be tin oxide, wherein the tin oxide may be SnO₂.

The carboxylic acid may be acetic acid or trifluoroacetic acid.

The dispersion solvent may be one selected from the group consisting of isopropyl alcohol (IPA), deionized water (DI water), and ethanol, or a combination thereof.

The stack may further include a substrate layer on a lower surface of the first electrode layer.

The photoactive layer may be a perovskite layer.

In accordance with another aspect of the present invention, a solar cell includes a substrate layer, a first electrode layer, a hole transport layer (HTL), a photoactive layer, an electron transport layer, and a second electrode layer stacked in sequence, wherein the hole transport layer or the electron transport layer includes a metal oxide layer, wherein the metal oxide layer is a uniform thin film of a metal oxide subjected to surface modification by attaching a carboxyl group (-COOH)-containing compound to a surface thereof.

The first electrode layer and the second electrode layer may each independently include one selected from the group consisting of indium tin oxide (ITO), indium cerium oxide (ICO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum-doped zinc oxide (AZO), fluorine tin oxide (FTO), and ZnO, or a combination thereof.

The electron transport layer may include one selected from the group consisting of Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide, Sc oxide, Sm oxide, Ga oxide, and SrTi oxide, or a combination thereof.

The hole transport layer may include one selected from the group consisting of tungsten oxide (WOₓ), molybdenum oxide (MoOₓ), vanadium oxide (V₂O₅), and nickel oxide (NiOₓ), or a combination thereof.

The substrate layer may include one selected from the group consisting of silicon oxide, aluminum oxide, indium tin oxide (ITO), fluorine tin oxide (FTO), glass, quartz, polyimide, polyethylene naphthalate (PEN), polyethylene terephthalate (PET), polymethyl methacrylate (PMMA), and polydimethylsiloxane (PDMS), or a combination thereof.

The photoactive layer may be a perovskite layer, wherein the perovskite layer may include one selected from the group consisting of CH₃NH₃PbI₃, CH₃NH₃PbIₓCl₃₋ₓ, MAPbI₃, CH₃NH₃PbIₓBr₃₋ₓ, CH₃NH₃PbClₓBr₃₋ₓ, HC(NH₂)₂PbI₃, HC(NH₂)₂PbIₓCl₃₋ₓ, HC(NH₂)₂PbIₓBr₃₋ₓ, HC(NH₂)₂PbClₓBr₃₋ₓ, (CH₃NH₃)(HC(NH₂)₂)_{1-y}PbI₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, and (CH₃NH₃)(HC(NH₂)₂)_{1-y}PbCIₓBr₃₋ₓ, or a combination thereof.

The solar cell may have a perovskite-perovskite tandem structure in which the perovskite layer includes a first perovskite layer and a second perovskite layer stacked on the first perovskite layer.

Alternatively, the solar cell may have a silicon-perovskite tandem structure in which the substrate layer includes a silicon solar cell.

### [Advantageous Effects]

The method for manufacturing solar cells according to the present invention enables formation of a hole transport layer or an electron transport layer including a uniform thin film of a metal oxide by ensuring good dispersion of a surface-modified metal oxide even in a polar solvent through addition of a hydroxide to a dispersion including the surface-modified metal oxide.

The hole transport layer or the electron transport layer including the uniform thin film of the metal oxide can significantly contribute to improving the performance of a solar cell.

### [Description of Drawings]

The following accompanying drawings are provided for illustration of exemplary embodiments of the invention, serve to aid in further understanding of the technical idea of the invention in conjunction with the detailed description of the invention, and are not intended to limit the scope of the invention.
FIG. 1 is a side view of a perovskite solar cell.
FIG. 2 is a side view of a perovskite solar cell according to another embodiment of the present invention.

### [Best Mode]

Hereinafter, exemplary embodiments of the present invention will be described in detail with reference to the accompanying drawings.

It should be understood that the following embodiments are provided for complete disclosure and thorough understanding of the invention by those skilled in the art, and that the present invention is not limited to these embodiments and may be embodied in different ways.

The terminology used herein is for the purpose of describing particular embodiments and is not intended to be limiting. As used herein, the singular forms "a," "an," and "the" are intended to include the plural forms as well, unless the context clearly indicates otherwise. As used herein, the terms "includes," "comprises," "including," and/or "comprising" specify the presence of stated features, steps, figures, operations, elements, components, and/or groups thereof, but do not preclude the presence or addition of one or more other features, steps, figures, operations, elements, components, and/or groups thereof. When an element is referred to as being "connected to" another element, that element may be directly connected to the other element or one or more intervening elements may be present.

Likewise, when an element is referred to as being "on" another element, that element may be directly on the other element or one or more intervening elements may be present. As used herein, the term "and/or" used in reference to a list of two or more items covers all of the following interpretations of the word: any of the items in the list, all of the items in the list, and any combination of the items in the list. Herein, terms of degree such as "about," "substantially," and the like, are used to mean at or near that number or degree, taking into account inherent manufacturing and material tolerances, and to prevent infringers from taking unfair advantage of disclosures that recite precise or absolute numbers for the purpose of providing understanding of the invention.

It should be noted that the drawings are not to precise scale and may be exaggerated in thickness of lines or size of components for descriptive convenience and clarity only. Like components will be denoted by like reference numerals throughout the specification.

A method for manufacturing solar cells according to the present invention includes manufacturing a stack including a first electrode layer, a hole transport layer (HTL), a photoactive layer, an electron transport layer, and a second electrode layer stacked in sequence, wherein the hole transport layer or the electron transport layer is formed by applying and drying a dispersion including a metal oxide subjected to surface modification with a carboxylic acid (R-COOH), a dispersion solvent, and a hydroxide.

Conventional solar cell manufacturing methods suffer from the problem that surface modification of a metal oxide cannot ensure sufficient dispersion of the metal oxide in a polar solvent such as deionized water (DI water) or ethanol, despite efficiency in improvement in dispersion of the metal oxide in a non-polar solvent such as isopropyl alcohol (IPA), which eventually leads to difficulty in formation of a thin metal oxide film using a dispersion including a metal oxide dispersed in a polar solvent.

The method for manufacturing solar cells according to the present invention can ensure good dispersion of a surface-modified metal oxide even in a polar solvent by properly adjusting the pH of a dispersion including the surface-modified metal oxide through addition of a hydroxide thereto, thereby enabling formation of a hole transport layer or an electron transport layer including a uniform thin film of the metal oxide.

As a result, a solar cell including the hole transport layer or the electron transport layer thus formed can have improved performance.

The dispersion may be basic and may have a pH of 8 to 13. Within this range of pH of the dispersion, the surface-modified metal oxide can be dispersed as uniformly as possible in the dispersion.

Although the hydroxide may be any hydroxide having a hydroxyl group (-OH) without particular limitation, more specifically, the hydroxide may be one selected from the group consisting of NH₄OH, LiOH, NaOH, KOH, RbOH, and CsOH, or a mixture thereof.

Further, the hydroxide may be an amine group-containing hydroxide, for example, tetramethylammonium hydroxide (TMAH) and tetrabutylammonium hydroxide (TBMH), without being limited.

The metal oxide may be tin oxide, more specifically SnO₂.

The carboxylic acid may be acetic acid or trifluoroacetic acid, without being limited thereto.

The dispersion solvent may be a non-polar solvent such as isopropyl alcohol (IPA) or a polar solvent such as deionized water (DI water) and ethanol. However, the dispersion solvent is not limited thereto and may include any solvent consistent with the objectives of the present invention, including one selected from the group consisting of the aforementioned solvents or a combination thereof.

The stack may further include a substrate layer on a lower surface of the first electrode layer, and the photoactive layer is preferably a perovskite layer. Details of each component of a solar cell manufactured by the method according to the present invention will be described below.

Another aspect of the present invention relates to a solar cell. Referring to FIG. 1, the solar cell includes a substrate layer 10, a first electrode layer 20, a hole transport layer (HTL) 30, a photoactive layer 40, an electron transport layer 50, and a second electrode layer 60 stacked in sequence, wherein the hole transport layer 30 or the electron transport layer 50 includes a metal oxide layer and the metal oxide layer is a uniform thin film of a metal oxide subjected to surface modification by attaching a carboxyl group (-COOH)-containing compound to a surface thereof.

Advantageously, the hole transport layer 30 or the electron transport layer 50 including the uniform thin film of the surface-modified metal oxide can significantly improve the performance of the solar cell 100.

The metal oxide may be tin oxide, more specifically SnO₂.

The substrate layer 10 may include a transparent material that allows light to pass therethrough. In addition, the substrate layer 10 may include a material that selectively transmits a desired wavelength of light therethrough. The substrate layer 10 may include, for example, a transparent conductive oxide (TCO), such as silicon oxide, aluminum oxide, indium tin oxide (ITO), and fluorine tin oxide (FTO), glass, quartz, or a polymer, wherein the polymer may include, for example, at least one selected from among polyimide, polyethylene naphthalate (PEN), polyethylene terephthalate (PET), polymethyl methacrylate (PMMA), and polydimethylsiloxane (PDMS).

The substrate layer 10 may have a thickness of 100 µm to 150 µm, for example, 125 µm. However, the material and thickness of the substrate layer 10 are not limited to those described above and may be appropriately selected in accordance with the technical idea of the present invention.

In other embodiments, a silicon solar cell itself may be used as the substrate layer 10, which will be described further below.

The first electrode layer 20 may be formed of a light-transmissive conductive material. The light-transmissive conductive material may include, for example, a transparent conductive oxide, a carbonaceous conductive material, and a metallic material. The transparent conductive oxide may include, for example, indium tin oxide (ITO), indium cerium oxide (ICO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum-doped zinc oxide (AZO), fluorine tin oxide (FTO), and ZnO. The carbonaceous conductive material may include, for example, graphene or carbon nanotubes, and the metallic material may include, for example, metal (Ag) nanowires or a thin metal film having a multilayer structure such as Au/Ag/Cu/Mg/Mo/Ti. As used herein, the term "transparent" refers to being able to transmit light at least to a certain degree and is not necessarily construed to mean completely transparent. It should be understood that the present invention is not limited to the embodiments described above and the aforementioned materials may include various other materials belonging thereto and may have a monolayer structure or a multilayer structure, among other variations.

The first electrode layer 20 may be formed on the substrate layer 10 by stacking, or may be integrally formed with the substrate layer 10.

The hole transport layer 30 may be stacked on the first electrode layer 20 and serves to transport holes from the photoactive layer 40 to the first electrode layer 20.

The hole transport layer 30 may include the metal oxide layer as described above, that is, the uniform thin film of the surface-modified metal oxide, or may include at least one metal oxide selected from among tungsten oxide (WOₓ), molybdenum oxide (MoOₓ), vanadium oxide (V₂O₅), nickel oxide (NiOₓ), and mixtures thereof. Although the hole transport layer 30 may include at least one selected from the group consisting of a monomeric hole transport material and a polymeric hole transport material, it will be understood that the present invention is not limited thereto and the hole transport layer 30 may include any hole transport material known in the art. For example, the monomeric hole transport material may include 2,2',7,7'-tetrakis(N,N-p-dimethoxy-phenylamino)-9,9'-spirobifluorene (spiro-MeOTAD), and the polymeric hole transport material may include poly(3-hexylthiophene) (P3HT), polytriarylamine (PTAA), or poly(3,4-ethylenedioxythiophene)-polystyrene sulfonate (PEDOT:PSS), without being limited thereto.

The hole transport layer 30 may further include a doping material, wherein the doping material may be selected from the group consisting of a Li dopant, a Co dopant, a Cu dopant, a Cs dopant, and combinations thereof, without being limited thereto.

The hole transport layer 30 may be formed by applying a precursor solution for the hole transport layer to the first electrode layer 20, followed by drying. In addition, prior to applying the precursor solution to the first electrode layer 20, UV-ozone treatment may be applied to the first electrode layer 20 to reduce the work function of the first electrode layer 20, remove impurities from the surface of the first electrode layer 20, and make the surface of the first electrode layer 20 hydrophilic. Application of the precursor solution may be performed by, for example, spin coating, without being limited thereto. The hole transport layer 30 thus formed may have a thickness of 10 nm to 500 nm.

Preferably, the photoactive layer 40 is a perovskite layer including a perovskite compound.

The solar cell 100 according to the present invention may employ a perovskite compound as a photoactive material that generates photoelectron-hole pairs through absorption of sunlight. Advantageously, perovskite has a direct band gap, a high light absorption coefficient of 1.5×10⁴ cm⁻¹ at 550 nm, good charge transfer capability, and high defect resistance.

Advantageously, the perovskite compound can form light absorbers forming the photoactive layer through a simple, easy, and low-cost process consisting of application and drying of a solution thereof. In particular, the perovskite compound can form coarse, granular light absorbers through spontaneous crystallization upon drying of the applied solution and has good conductivity for both electrons and holes.

The perovskite compound may be represented by Formula 1:

[Formula 1] ABX₃

(where A is a monovalent organoammonium cation or metal cation, B is a divalent metal cation, and X is a halogen anion).

The perovskite compound may include, for example, CH₃NH₃PbI₃, CH₃NH₃PbIₓCl₃₋ₓ, MAPbI₃, CH₃NH₃PbIₓBr₃₋ₓ, CH₃NH₃PbClₓBr₃₋ₓ, HC(NH₂)₂PbI₃, HC(NH₂)₂PbIₓCl₃₋ₓ, HC(NH₂)₂PbIₓBr₃₋ₓ, HC(NH₂)₂PbClₓBr₃₋ₓ, (CH₃NH₃)(HC(NH₂)₂)_{1-y}PbI₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, and (CH₃NH₃)(HC(NH₂)₂)_{1-y}PbCIₓBr₃₋ₓ (0≤x, y≤1). In addition, the perovskite compound may include an ABX₃ compound, A of which is partially doped with Cs.

The electron transport layer 50 may be disposed on the photoactive layer 40 and may serve to facilitate transfer of electrons from the photoactive layer 40 to the second electrode layer 60.

The electron transport layer 50 may include the metal oxide layer as described above, that is, the uniform thin film of the surface-modified metal oxide, or may include a typical metal oxide layer. For example, the electron transport layer 50 may include Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide, Sc oxide, Sm oxide, Ga oxide, and SrTi oxide. In some embodiments, the electron transport layer 50 may be a compact layer of TiO₂, SnO₂, WO₃, or TiSrO₃. The electron transport layer 50 may further include an n-type or p-type dopant as needed.

Various interlayer structures and/or materials other than those described above may be applied to the hole transport layer 30, the photoactive layer 40 and the electron transport layer 50 as described above to constitute the solar cell 100. For example, the positions of the hole transport layer 30 and the electron transport layer 50 may be interchanged.

The second electrode layer 60 may be formed of a light-transmissive conductive material. The light-transmissive conductive material may include, for example, a transparent conductive oxide, a carbonaceous conductive material, and a metallic material. The transparent conductive oxide may include, for example, indium tin oxide (ITO), indium cerium oxide (ICO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum-doped zinc oxide (AZO), fluorine tin oxide (FTO), and ZnO. The carbonaceous conductive material may include, for example, graphene or carbon nanotubes, and the metallic material may include, for example, metal (Ag) nanowires or a thin metal film having a multilayer structure such as Au/Ag/Cu/Mg/Mo/Ti. As used herein, the term "transparent" refers to being able to transmit light at least to a certain degree and is not necessarily construed to mean completely transparent. It should be understood that the present invention is not limited to the embodiments described above and the aforementioned materials may include various other materials belonging thereto and may have a monolayer structure or a multilayer structure, among other variations.

Although not shown in FIG. 1, the solar cell 100 may further include a bus electrode (not shown) disposed on the second electrode layer 60 to reduce resistance of the second electrode layer 60 and further facilitate charge transfer. The bus electrode may be formed of Ag, Mg, Al, Pt, Pd, Au, Ni, Nd, Ir, Cr, and/or a compound thereof.

FIG. 2 is a side view of a perovskite solar cell according to another embodiment of the present invention.

Referring to FIG. 2, a solar cell 100 according to the present invention may have a perovskite-perovskite tandem structure in which the perovskite layer as described above includes a first perovskite layer 40a and a second perovskite layer 40b stacked on the first perovskite layer 40a.

Here, the first perovskite layer 40a and the second perovskite layer 40b may have different energy bandgaps. Use of materials having various energy bandgaps can ensure effective use of light energy over a wide spectral range.

By way of example, such a tandem solar cell may have an arrangement in which a single-junction solar cell including an absorber layer with a relatively large bandgap is disposed at a light-receiving side and a single-junction solar cell including an absorber layer with a relatively small bandgap is disposed opposite the light-receiving side. Accordingly, the tandem solar cell can shift a threshold wavelength of absorption to a longer wavelength by absorbing shorter-wavelength light through a front surface thereof and absorbing longer-wavelength light through a back surface thereof. As a result, the tandem solar cell can advantageously achieve effective light absorption over the entire wavelength range.

Alternatively, the solar cell 100 may have a silicon-perovskite tandem structure.

Here, the substrate layer 10 as described above may be or include a silicon solar cell.

The silicon solar cell may be a typical silicon solar cell known in the art, and may have any structure or shape consistent with the objectives of the present invention.

Various interlayer structures and/or materials other than those described above may be applied to the hole transport layer 30, the photoactive layer 40, and the electron transport layer 50 as described above to constitute the solar cell 100.

Although exemplary embodiments have been described using specific terms, such description is for illustration only and is not intended to limit the scope of the invention. It will be apparent to those skilled in the art that changes and variations may be made without departing from the spirit or scope of the invention. For example, those skilled in the art will recognize that the method for manufacturing solar cells according to the embodiments described with reference to FIG. 1 and a solar cell manufactured thereby may be subject to various variations. Therefore, the scope of the invention should be defined by the technical ideas recited in the accompanying claims, rather than by the embodiments described herein.

### [Industrial Applicability]

The present invention is applicable to the field of manufacture of perovskite solar cells.

## Claims

1. A method for manufacturing solar cells, comprising manufacturing a stack comprising a first electrode layer, a hole transport layer (HTL), a photoactive layer, an electron transport layer, and a second electrode layer stacked in sequence, wherein the hole transport layer or the electron transport layer is formed by applying and drying a dispersion comprising a metal oxide subjected to surface modification with a carboxylic acid (R-COOH), a dispersion solvent, and a hydroxide.

2. The method according to claim 1, wherein the dispersion has a pH of 8 to 13.

3. The method according to claim 1, wherein the hydroxide is one selected from the group consisting of NH₄OH, LiOH, NaOH, KOH, RbOH, CsOH, tetramethylammonium hydroxide (TMAH), and tetrabutylammonium hydroxide (TBMH), or a mixture thereof.

4. The method according to claim 1, wherein the metal oxide is tin oxide.

5. The method according to claim 4, wherein the tin oxide is SnO₂.

6. The method according to claim 1, wherein the carboxylic acid is acetic acid or trifluoroacetic acid.

7. The method according to claim 1, wherein the dispersion solvent is one selected from the group consisting of isopropyl alcohol (IPA), deionized water (DI water), and ethanol, or a combination thereof.

8. The method according to claim 1, wherein the stack further comprises a substrate layer on a lower surface of the first electrode layer.

9. The method according to claim 1, wherein the photoactive layer is a perovskite layer.

10. A solar cell comprising a substrate layer, a first electrode layer, a hole transport layer (HTL), a photoactive layer, an electron transport layer, and a second electrode layer stacked in sequence,
wherein the hole transport layer or the electron transport layer comprises a metal oxide layer, the metal oxide layer being a uniform thin film of a metal oxide subjected to surface modification by attaching a carboxyl group (-COOH)-containing compound to a surface thereof.

11. The solar cell according to claim 10, wherein the metal oxide is tin oxide.

12. The solar cell according to claim 11, wherein the tin oxide is SnO₂.

13. The solar cell according to claim 10, wherein the first electrode layer and the second electrode layer each independently comprise one selected from the group consisting of indium tin oxide (ITO), indium cerium oxide (ICO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum-doped zinc oxide (AZO), fluorine tin oxide (FTO), and ZnO, or a combination thereof.

14. The solar cell according to claim 10, wherein the electron transport layer comprises one selected from the group consisting of Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide, Sc oxide, Sm oxide, Ga oxide, and SrTi oxide, or a combination thereof.

15. The solar cell according to claim 10, wherein the hole transport layer comprises one selected from the group consisting of tungsten oxide (WOₓ), molybdenum oxide (MoOₓ), vanadium oxide (V₂O₅), and nickel oxide (NiOₓ), or a combination thereof.

16. The solar cell according to claim 10, wherein the substrate layer comprises one selected from the group consisting of silicon oxide, aluminum oxide, indium tin oxide (ITO), fluorine tin oxide (FTO), glass, quartz, polyimide, polyethylene naphthalate (PEN), polyethylene terephthalate (PET), polymethyl methacrylate (PMMA), and polydimethylsiloxane (PDMS), or a combination thereof.

17. The solar cell according to claim 10, wherein the photoactive layer is a perovskite layer.

18. The solar cell according to claim 17, wherein the perovskite layer comprises one selected from the group consisting of CH₃NH₃PbI₃, CH₃NH₃PbIₓCl₃₋ₓ, MAPbI₃, CH₃NH₃PbIₓBr₃₋ₓ, CH₃NH₃PbClₓBr₃₋ₓ, HC(NH₂)₂PbI₃, HC(NH₂)₂PbIₓCl₃₋ₓ, HC(NH₂)₂PbIₓBr₃₋ₓ, HC(NH₂)₂PbClₓBr₃₋ₓ, (CH₃NH₃)(HC(NH₂)₂)_{1-y}PbI₃, (CH₃NH₃)(HC(NH₂)₂)_{1-y}PbIₓCl₃₋ₓ, (CH₃NH₃)(HC(NH₂)₂)_{1-y}PbIₓBr₃₋ₓ, and (CH₃NH₃)(HC(NH₂)₂)_{1-y}PbClₓBr₃₋ₓ, or a combination thereof.

19. The solar cell according to claim 17, wherein the solar cell has a perovskite-perovskite tandem structure in which the perovskite layer comprises a first perovskite layer and a second perovskite layer stacked on the first perovskite layer.

20. The solar cell according to claim 17, wherein the solar cell has a silicon-perovskite tandem structure in which the substrate layer comprises a silicon solar cell.
